# EUROPEAN PATENT APPLICATION

(11) **EP 4 672 311 A1**
(43) Date of publication of application: **31.12.2025**
(21) Application number: 25185048.3
(22) Date of filing: 24.06.2025
(51) Int. Cl.: H01L 21/768, H01L 23/532

(54) **TECHNOLOGIES FOR AIR GAPS IN SEMICONDUCTOR DIES WITH ALUMINUM OXIDE LINERS**

(30) Priority: 29.06.2024 US 202418759809
(71) Applicant: Intel Corporation, Santa Clara, CA 95054 (US)
(72) Inventor: PEER, Akshit, Hillsboro 97124 (US); DUTTA, Ananya, Portland 97229 (US); SUKRITTANON, Supanee, North Plains 97133 (US); NASKAR, Sudipto, Portland 97229 (US); KOBRINSKY, Mauro J., Portland 97229 (US)
(74) Representative: 2SPL Patentanwälte PartG mbB

(57) **Abstract**

Technologies for air gaps in semiconductor dies with aluminum oxide liners are disclosed. In an illustrative embodiment, high-aspect-ratio traces on an interconnect layer of a semiconductor die have a relatively narrow pitch. In order to reduce the capacitance between neighboring traces, an air gap is present. A liner above the air gap prevents the air gap from being filled during the semiconductor processing. In an illustrative embodiment, the liner is aluminum oxide, which may prevent stress induced leakage current (SILC) that may result when using silicon oxide or other materials.

## Description

### BACKGROUND

As transistor density on a semiconductor die increases, the density of interconnects to connect the transistors on the die has increased as well. High aspect-ratio traces can provide high-density interconnects with relatively low resistance. However, high-aspect-ratio traces that are close to each other also have high capacitance, which can limit performance.

### BRIEF DESCRIPTION OF THE DRAWINGS

FIG. 1 is an isometric view of an integrated circuit component.
FIG. 2 is a cross-sectional view of one embodiment of the integrated circuit component of FIG. 1.
FIG. 3 is a cross-sectional view of one embodiment of part of one interconnect layer of the integrated circuit component of FIG. 1.
FIG. 4 is a simplified flow diagram of at least one embodiment of a method for forming the interconnect layer of FIG. 3.
FIG. 5 is a cross-sectional side view at one step of the method of FIG. 4.
FIG. 6 is a cross-sectional side view at one step of the method of FIG. 4.
FIG. 7 is a cross-sectional side view at one step of the method of FIG. 4.
FIG. 8 is a cross-sectional side view at one step of the method of FIG. 4.
FIG. 9 is a cross-sectional side view at one step of the method of FIG. 4.
FIG. 10 is a top view of a wafer and dies that may be included in a microelectronic assembly, in accordance with any of the embodiments disclosed herein.
FIG. 11 is a cross-sectional side view of an integrated circuit device that may be included in a microelectronic assembly, in accordance with any of the embodiments disclosed herein.
FIGS. 12A-12D are perspective views of example planar, gate-all-around, and stacked gate-all-around transistors.
FIG. 13 is a cross-sectional side view of an integrated circuit device assembly that may include a microelectronic assembly, in accordance with any of the embodiments disclosed herein.
FIG. 14 is a block diagram of an example electrical device that may include a microelectronic assembly, in accordance with any of the embodiments disclosed herein.

### DETAILED DESCRIPTION

In various embodiments disclosed herein, an integrated circuit component includes one or more interconnect layers with air gaps between traces. In an illustrative embodiment, the traces are high aspect-ratio ruthenium traces, offering a relatively narrow pitch and low resistance, but with a high capacitance. In order to reduce the capacitance, part of the volume between neighboring traces is filled with air, rather than another material with a higher dielectric constant. During manufacturing, a sacrificial material is deposited between the traces, a liner is deposited over the sacrificial layer, and then the sacrificial layer is removed, creating a gap. Additional layers may then be deposited over the liner without filling in the gap. In an illustrative embodiment, aluminum oxide may be used to form the liner. Aluminum oxide may avoid issues from stress-induced leakage current (SILC) that may result when using silicon oxide or other materials.

As used herein, the phrase "communicatively coupled" refers to the ability of a component to send a signal to or receive a signal from another component. The signal can be any type of signal, such as an input signal, an output signal, or a power signal. A component can send or receive a signal to another component to which it is communicatively coupled via a wired or wireless communication medium (e.g., conductive traces, conductive contacts, air). Examples of components that are communicatively coupled include integrated circuit dies located in the same package that communicate via an embedded bridge in a package substrate and an integrated circuit component attached to a printed circuit board that send signals to or receives signals from other integrated circuit components or electronic devices attached to the printed circuit board.

In the following description, specific details are set forth, but embodiments of the technologies described herein may be practiced without these specific details. Well-known circuits, structures, and techniques have not been shown in detail to avoid obscuring an understanding of this description. Phrases such as "an embodiment," "various embodiments," "some embodiments," and the like may include features, structures, or characteristics, but not every embodiment necessarily includes the particular features, structures, or characteristics.

Some embodiments may have some, all, or none of the features described for other embodiments. "First," "second," "third," and the like describe a common object and indicate different instances of like objects being referred to. Such adjectives do not imply objects so described must be in a given sequence, either temporally or spatially, in ranking, or any other manner. "Connected" may indicate elements are in direct physical or electrical contact, and **"coupled"** may indicate elements co-operate or interact, but they may or may not be in direct physical or electrical contact. Furthermore, the terms "comprising," "including," "having," and the like, as used with respect to embodiments of the present disclosure, are synonymous. Terms modified by the word "substantially" include arrangements, orientations, spacings, or positions that vary slightly from the meaning of the unmodified term. For example, the central axis of a magnetic plug that is substantially coaxially aligned with a through hole may be misaligned from a central axis of the through hole by several degrees. In another example, a substrate assembly feature, such as a through width, that is described as having substantially a listed dimension can vary within a few percent of the listed dimension. Further, when a particular feature, structure, or characteristic is described in connection with an embodiment, it is submitted that it is within the knowledge of one skilled in the art to effect such feature, structure, or characteristic in connection with other embodiments whether or not explicitly described. Additionally, it should be appreciated that items included in a list in the form of "at least one A, B, and C" can mean (A); (B); (C); (A and B); (A and C); (B and C); or (A, B, and C). Similarly, items listed in the form of "at least one of A, B, or C" can mean (A); (B); (C); (A and B); (A and C); (B and C); or (A, B, and C).

The disclosed embodiments may be implemented, in some cases, in hardware, firmware, software, or any combination thereof. The disclosed embodiments may also be implemented as instructions carried by or stored on a transitory or non-transitory machine-readable (e.g., computer-readable) storage medium, which may be read and executed by one or more processors. A machine-readable storage medium may be embodied as any storage device, mechanism, or other physical structure for storing or transmitting information in a form readable by a machine (e.g., a volatile or non-volatile memory, a media disc, or other media device).

It will be understood that in the examples shown and described further below, the figures may not be drawn to scale and may not include all possible layers and/or circuit components. In addition, it will be understood that although certain figures illustrate transistor designs with source/drain regions, electrodes, etc. having orthogonal (e.g., perpendicular) boundaries, embodiments herein may implement such boundaries in a substantially orthogonal manner (e.g., within +/- 5 or 10 degrees of orthogonality) due to fabrication methods used to create such devices or for other reasons.

Reference is now made to the drawings, which are not necessarily drawn to scale, wherein similar or same numbers may be used to designate the same or similar parts in different figures. The use of similar or same numbers in different figures does not mean all figures including similar or same numbers constitute a single or same embodiment. Like numerals having different letter suffixes may represent different instances of similar components. The drawings illustrate generally, by way of example, but not by way of limitation, various embodiments discussed in the present document.

In the following description, for purposes of explanation, numerous specific details are set forth in order to provide a thorough understanding thereof. It may be evident, however, that the novel embodiments can be practiced without these specific details. In other instances, well-known structures and devices are shown in block diagram form in order to facilitate a description thereof. The intention is to cover all modifications, equivalents, and alternatives within the scope of the claims.

As used herein, the phrase "located on" in the context of a first layer or component located on a second layer or component refers to the first layer or component being directly physically attached to the second part or component (no layers or components between the first and second layers or components) or physically attached to the second layer or component with one or more intervening layers or components.

As used herein, the term "adjacent" refers to layers or components that are in physical contact with each other. That is, there is no layer or component between the stated adjacent layers or components. For example, a layer X that is adjacent to a layer Y refers to a layer that is in physical contact with layer Y.

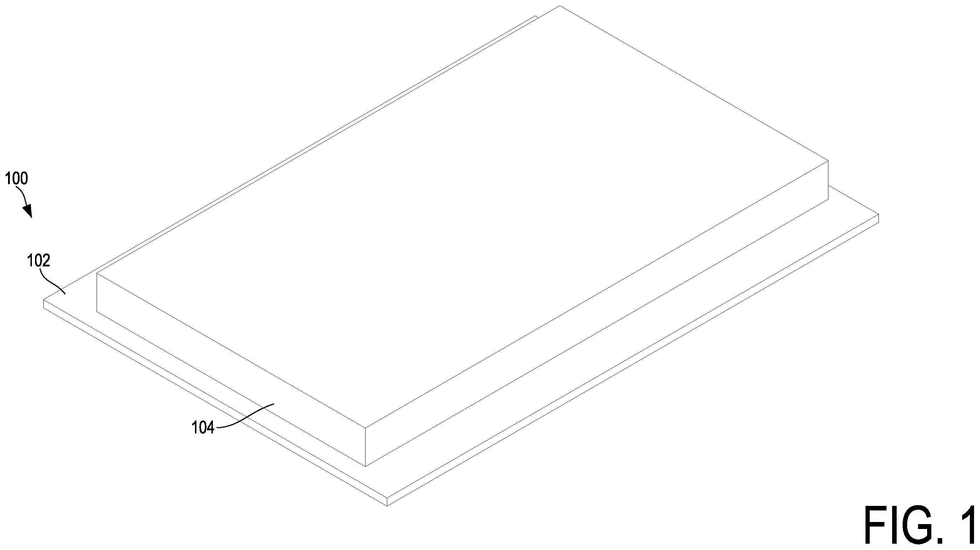

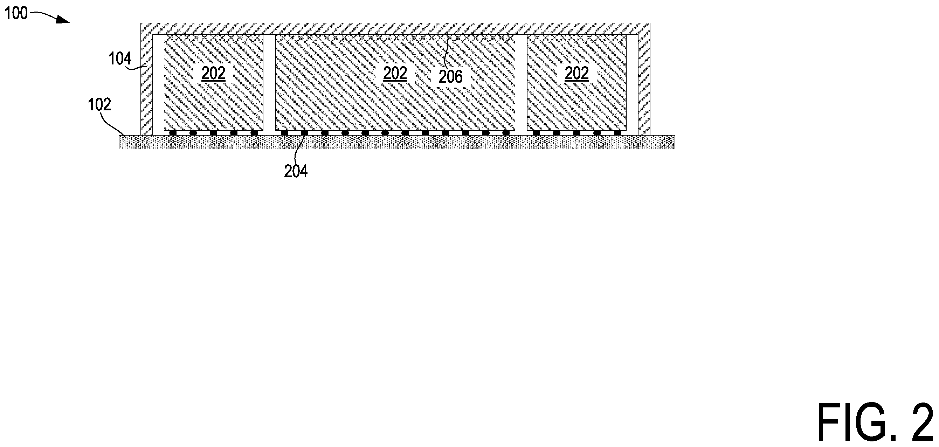

Referring now to FIGS. 1-2, in one embodiment, an integrated circuit component 100 includes a circuit board 102, one or more integrated circuit (IC) dies 202, and an integrated heat spreader (IHS) 104. FIG. 1 shows a perspective view of the integrated circuit component 100, and FIG. 2 shows a cross-sectional view of one embodiment of the integrated circuit component 100. In an illustrative embodiment, the one or more IC dies 202 are mounted on the circuit board 102. The integrated circuit component 100 may include other components, such as additional IC dies, components such as capacitors, inductors, voltage regulators, etc.

In an illustrative embodiment, the ICs 202 are connected to the circuit board 102 with solder balls 204. A thermal interface material (TIM) 206 is between the IC dies 202 and the IHS 104. The TIM 206 may be any suitable material, such as a silver thermal compound.

The illustrative circuit board 102 may be made from ceramic, glass, and/or organic-based materials with fiberglass and resin, such as FR-4. The circuit board 102 may have any suitable length or width, such as 10-500 millimeters. The circuit board 102 may have any suitable thickness, such as 0.2-5 millimeters. The circuit board 102 may support additional components besides the components shown in FIGS. 1-2, such as additional photonic or electronic integrated circuit components, a memory device such as a static random access memory (SRAM) device, additional circuit components, etc.

The one or more IC dies 202 may include any suitable electronic integrated circuit component, such as resistors, capacitors, inductors, transistors, etc. The one or more IC dies 202 may include any suitable analog and/or digital circuitry, such as a processor, a memory, an application-specific integrated circuit (ASIC), a field-programmable gate array (FPGA), etc. The IC dies 202 may have any suitable length or width, such as 1-300 millimeters. The IC dies 202 may have any suitable thickness, such as 0.05-5 millimeters. The IHS 104 may be made of any suitable material with a high thermal conductivity, such as copper, aluminum, other metals, metal alloys, coated metals, combinations of metals, etc.

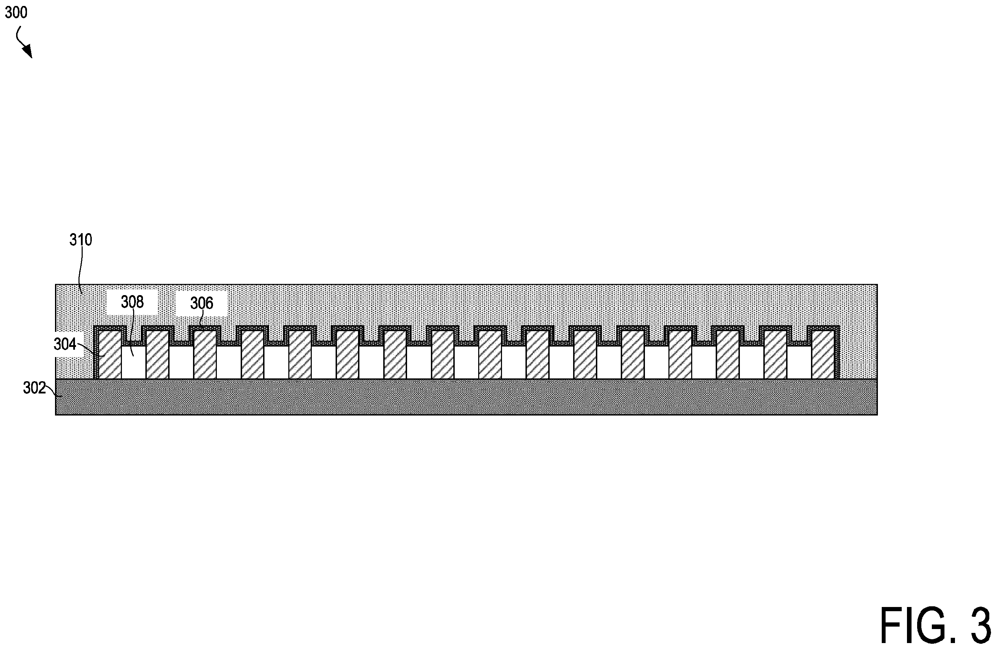

Referring now to FIG. 3, in one embodiment, an integrated circuit die 300, which may be an integrated circuit die 202, includes a layer 302, several traces 304 or pads 304 formed on top of the layer 302, and a liner 306 adj acent to the traces 304. An air gap 308 may be present between neighboring traces 304, the lower layer 302, and the liner 306. It should be noted that the dielectric constant of the gas in the air gap 308 is less than for a typical low-k dielectric in a semiconductor, such as silicon oxide. As a result, the capacitance between the traces 304 is lower than using a typical low-k dielectric. The lower capacitance can reduce signal delay and cross-talk, improve signal integrity, and increase overall performance.

In an illustrative embodiment, the layer with the traces 304 is the lowest level interconnect (e.g., an M0 layer), and the layer 302 below the traces 304 includes transistors or other circuit components. In such an embodiment, the traces 304 may be connected by vias to sources, drains, gates, capacitors, and/or the like. Additionally or alternatively, the layer with the traces 304 may be a higher level interconnect, such as an M1, M2, etc. The traces 304 may extend into and out of the page and/or connect through vias to the layer above and/or the layer below. In some embodiments, the vias to the layer above may extend through the liner 306 to contact the trace 304.

In an illustrative embodiment, the traces 304 are high-aspect ratio traces 304 with a narrow pitch. For example, the traces 304 may have a width of 10 nanometers, a height of 40 nanometers, and a pitch of 20 nanometers. In general, the traces 304 may have, e.g., a width of 10-50 nanometers, a height of 10-100 nanometers, and a pitch of 15-100 nanometers, and an aspect ratio of 1-10. As used herein, the aspect ratio of a trace is the height of the trace divided by the width of the trace. In an illustrative embodiment, the traces 304 are made of ruthenium. In other embodiments, the traces 304 may be made of a different material, such as molybdenum, tungsten, aluminum, nickel, copper, or other conductor. In an illustrative embodiment, the traces 304 are formed using a subtractive manufacturing process, in which case copper may not be used.

In an illustrative embodiment, the liner 306 is aluminum oxide. In another embodiment, the liner 306 may be a multilayer liner, such as aluminum oxide sandwiched between two silicon oxide layers. In an illustrative embodiment, the liner 306 may be about 2 nanometers thick. In other embodiments, the liner 306 may be 1-4 nanometers thick. In an illustrative multilayer liner 306, the liner 306 may include a silicon oxide layer that is 7 Angstroms thick, an aluminum oxide layer that is 5 Angstroms thick, and another silicon oxide layer that is 7 Angstroms thick. In general, the various layers of a multilayer liner 306 may have any suitable thickness, such as 3-10 Angstroms. In some embodiments, another material may be used for the liner 306, such as silicon nitride.

In an illustrative embodiment, the liner 306 extends partially down the sides of the traces 304, as shown in the figure. The liner 306 may extend any suitable fraction down the sides of the traces 304, such as 10-40%. In some embodiments, the liner 306 may extend along the tops of the traces 304 without extending partially down the sides of the traces 304.

In an illustrative embodiment, the gap 308 is filled with air. In other embodiments, the gap 308 may include any suitable gas, such as oxygen, nitrogen, argon or other noble gas, carbon dioxide, etc. In an illustrative embodiment, the gas in the gap 308 is at about atmospheric pressure. In other embodiments, the gas in the gap 308 may be under any suitable pressure, such as 0-2 bars of pressure. In some embodiments, the gap 308 may be a vacuum filled with nothing or with a low-pressure gas.

In an illustrative embodiment, a dielectric layer 310 is on top of the liner. The dielectric layer 310 may be made of any suitable material, such as silicon oxide, silicon nitride, organosilicate glass, fluorinated silicate glass, spin-on polymer, siloxanes, and/or the like. The dielectric layer 310 may have any suitable thickness above the liner, such as 2-20 nanometers. In an illustrative embodiment, the dielectric layer 310 above the liner 306 is about 10 nanometers thick.

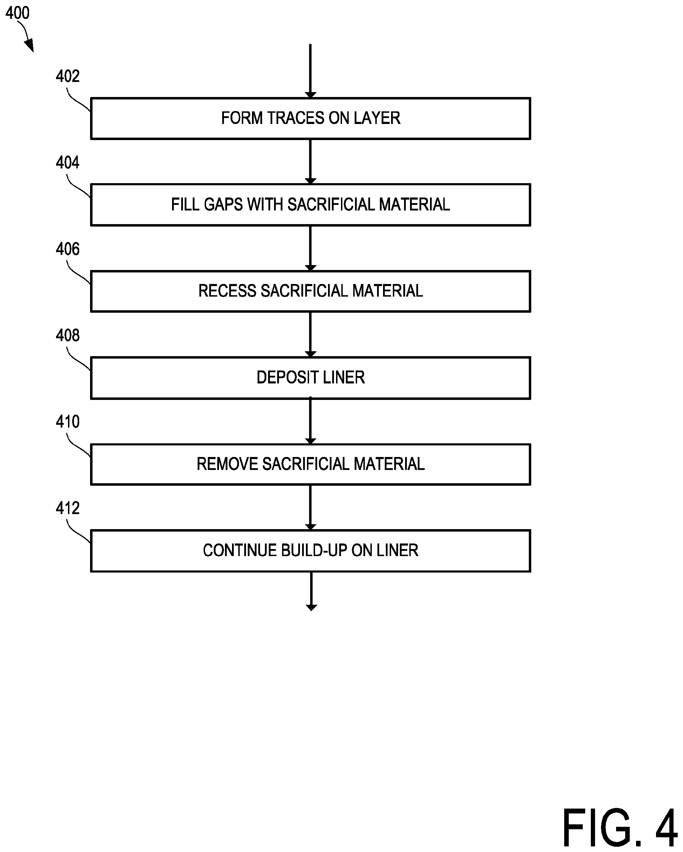

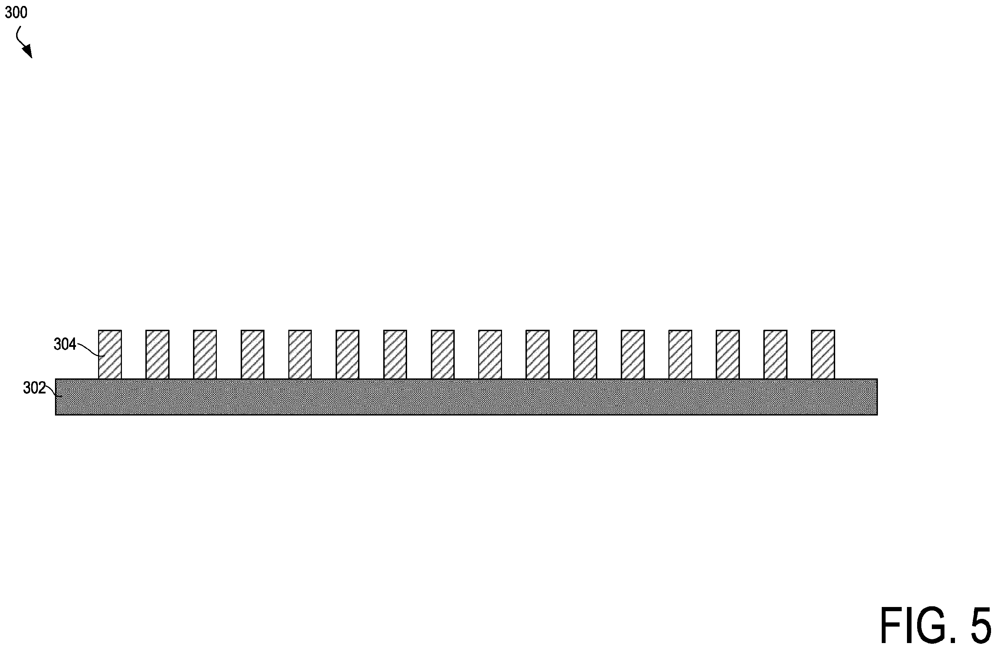

Referring now to FIG. 4, in one embodiment, a flowchart for a method 400 for creating an air gap 308 between traces 304 is shown. The method 400 may be executed by a technician and/or by one or more automated machines. In some embodiments, one or more machines may be programmed to do some or all of the steps of the method 400. Such a machine may include, e.g., a memory, a processor, data storage, etc. The memory and/or data storage may store instructions that, when executed by the machine, cause the machine to perform some or all of the steps of the method 400. The method 400 may use any suitable set of techniques that are used in semiconductor processing, such as chemical vapor deposition, atomic layer deposition, physical vapor deposition, molecular beam epitaxy, pulsed laser deposition, layer transfer, photolithography, ion implantation, dry etching, wet etching, thermal treatments, etc. FIGS. 5-9 show various stages of the method 400.

The method 400 begins in block 402, in which traces 304 are formed on the layer 302, as shown in FIG. 5. In an illustrative embodiment, the traces 304 are formed using subtractive manufacturing, where a layer of material is deposited and selectively removed to form the traces 304.

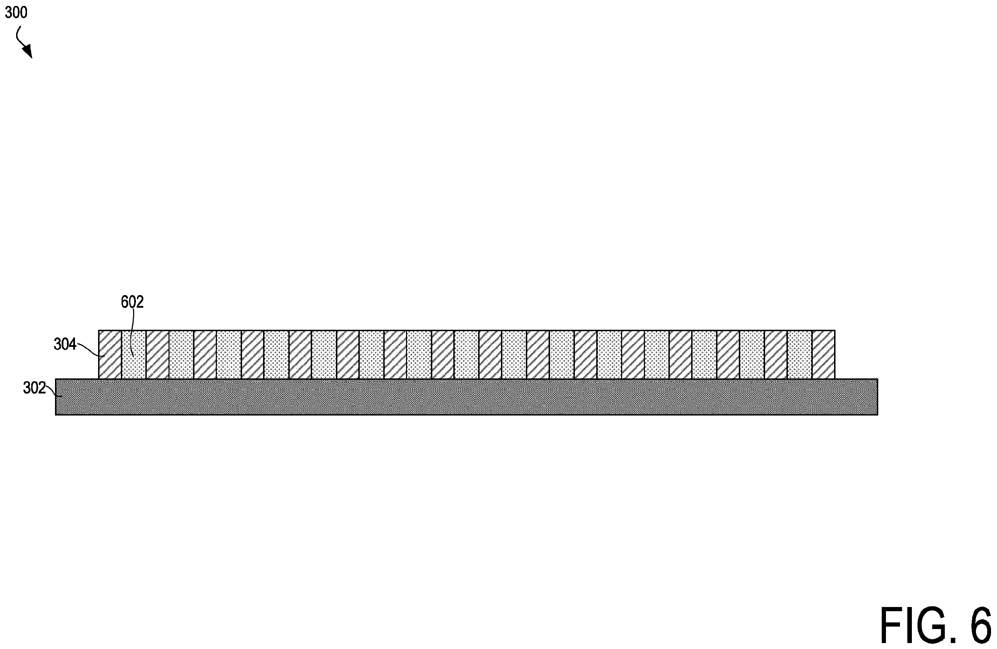

In block 404, the gaps between the traces 304 is filled with a sacrificial material 602, such as ashless carbon 602, as shown in FIG. 6. The ashless carbon 602 may be a high-purity carbon that can thermalize or oxidize without leaving any significant amount of ash or other residue. In other embodiments, other materials may be used besides ashless carbon 602.

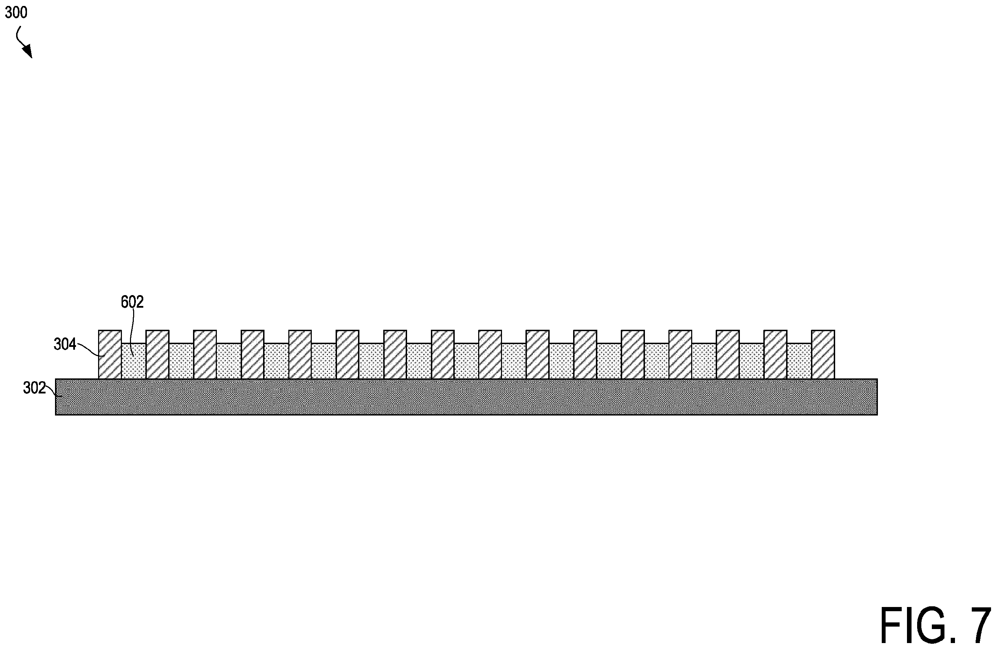

In block 406, in some embodiments, the sacrificial material 602 may be recessed, as shown in FIG. 7. The recess allows for sufficient dielectric between traces in order to successfully integrate the next layer via without the risk of etch punching through into the air gap 308.

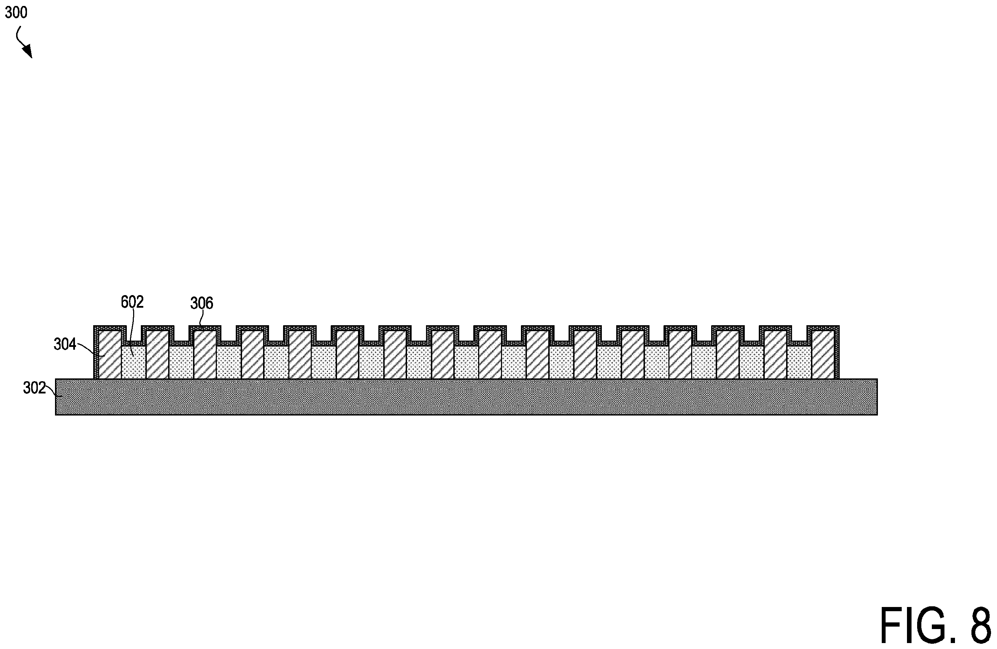

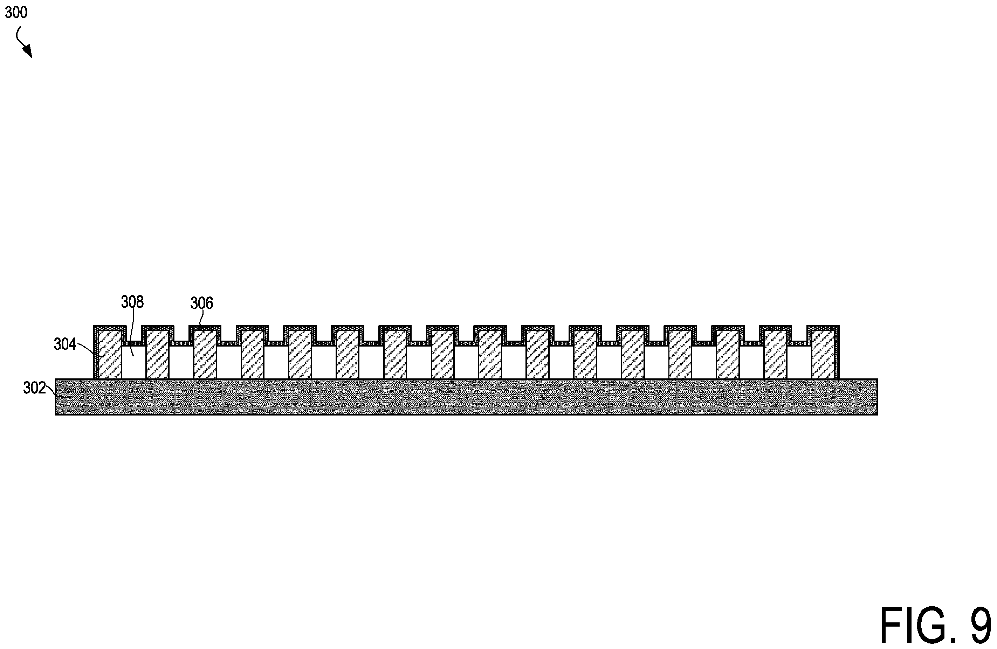

In block 408, a liner 306 is deposited over the sacrificial material 602, as shown in FIG. 8. In block 410, the sacrificial material 602 is removed, as shown in FIG. 9. For example, if the sacrificial material 602 is ashless carbon, the sacrificial material 602 may be removed by heating the die 300 to a high temperature, such as 400 °C, under a nitrogen atmosphere. In some embodiments, the sacrificial material 602 may be allowed to oxidize with oxygen. The oxygen may diffuse through the liner 306 to combine with the ashless carbon to form carbon dioxide, which can then diffuse through the liner 306. In such an embodiment, the liner 306, along with other components such as the traces 304 and layer 302, may fully enclose the gaps 308 before the sacrificial liner 602 is removed. In some embodiments, the sacrificial liner 602 may be removed in a different manner, such as by etching. In such an embodiment, the liner 306 and other components may not fully enclose the gaps 308, allowing an etchant to remove the sacrificial layer 602.

In block 412, the build-up of additional layers on the liner 306 can continue. It should be appreciated that the liner 306 prevents additional material, such as the interlayer dielectric 310, from filling in the gaps 308.

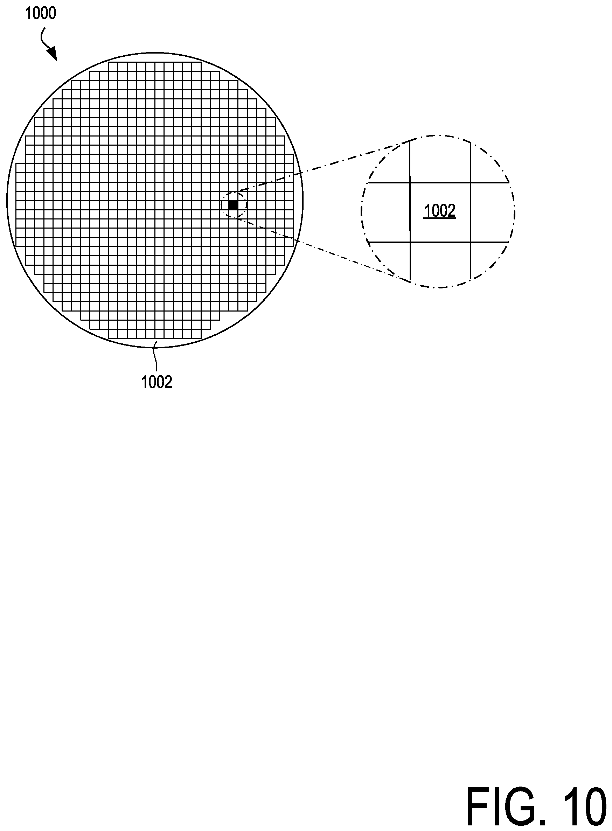

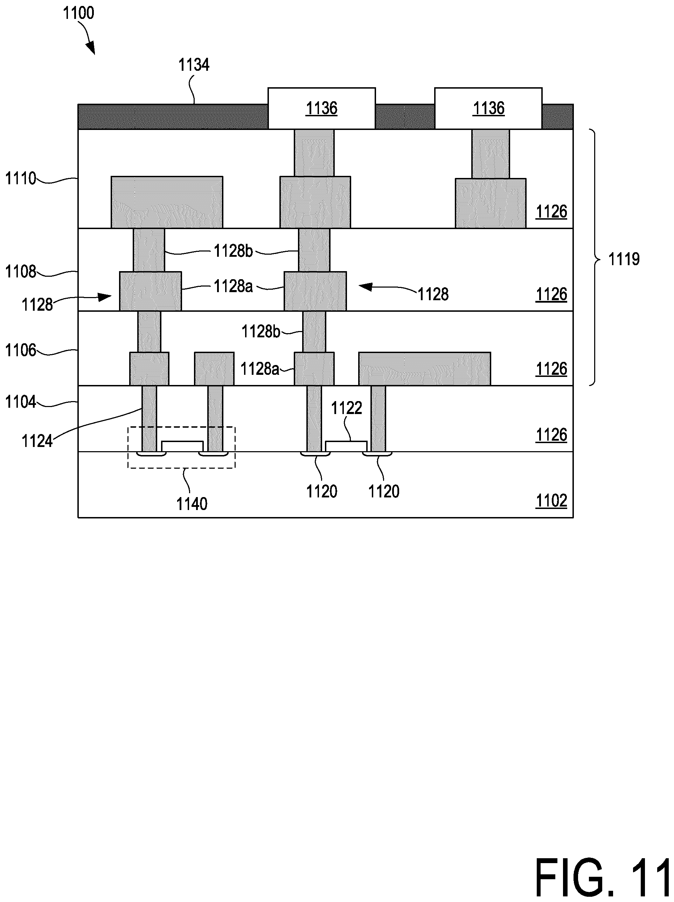

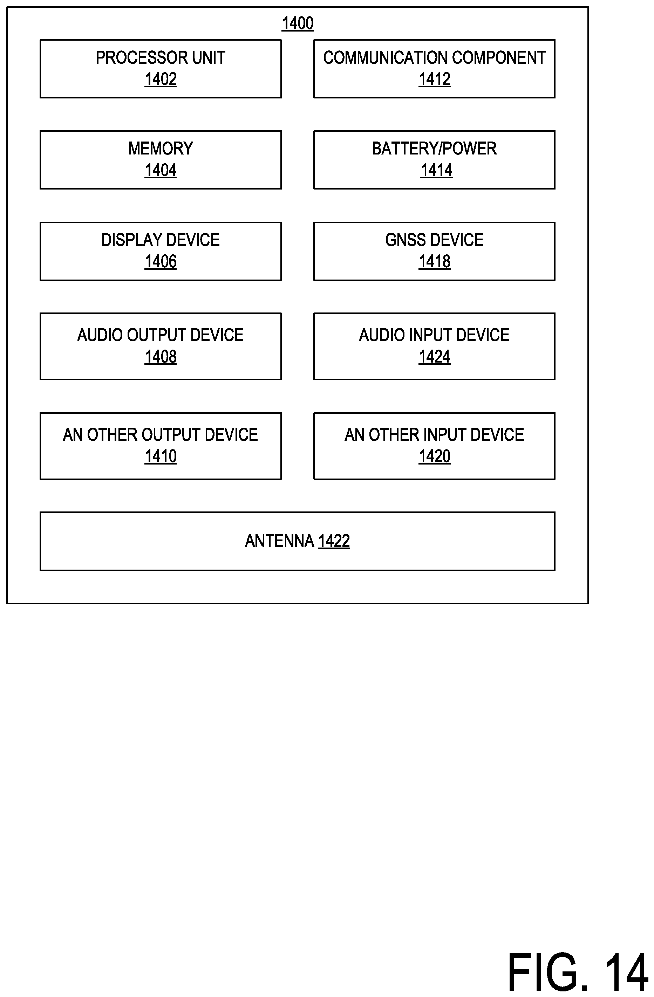

FIG. 10 is a top view of a wafer 1000 and dies 1002 that may be included in any of the integrated circuit components 100 disclosed herein (e.g., as any suitable ones of the dies 202). The wafer 1000 may be composed of semiconductor material and may include one or more dies 1002 having integrated circuit structures formed on a surface of the wafer 1000. The individual dies 1002 may be a repeating unit of an integrated circuit product that includes any suitable integrated circuit. After the fabrication of the semiconductor product is complete, the wafer 1000 may undergo a singulation process in which the dies 1002 are separated from one another to provide discrete "chips" of the integrated circuit product. The die 1002 may be any of the dies 202 disclosed herein. The die 1002 may include one or more transistors (e.g., some of the transistors 1140 of FIG. 11, discussed below), supporting circuitry to route electrical signals to the transistors, passive components (e.g., signal traces, resistors, capacitors, or inductors), and/or any other integrated circuit components. In some embodiments, the wafer 1000 or the die 1002 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1002. For example, a memory array formed by multiple memory devices may be formed on a same die 1002 as a processor unit (e.g., the processor unit 1402 of FIG. 14) or other logic that is configured to store information in the memory devices or execute instructions stored in the memory array. Various ones of the integrated circuit components 100 disclosed herein may be manufactured using a die-to-wafer assembly technique in which some dies 202 are attached to a wafer 1000 that include others of the dies 202, and the wafer 1000 is subsequently singulated.

FIG. 11 is a cross-sectional side view of an integrated circuit device 1100 that may be included in any of the integrated circuit components 100 disclosed herein (e.g., in any of the dies 202). One or more of the integrated circuit devices 1100 may be included in one or more dies 1002 (FIG. 10). The integrated circuit device 1100 may be formed on a die substrate 1102 (e.g., the wafer 1000 of FIG. 10) and may be included in a die (e.g., the die 1002 of FIG. 10). The die substrate 1102 may be a semiconductor substrate composed of semiconductor material systems including, for example, n-type or p-type materials systems (or a combination of both). The die substrate 1102 may include, for example, a crystalline substrate formed using a bulk silicon or a silicon-on-insulator (SOI) substructure. In some embodiments, the die substrate 1102 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1102. Although a few examples of materials from which the die substrate 1102 may be formed are described here, any material that may serve as a foundation for an integrated circuit device 1100 may be used. The die substrate 1102 may be part of a singulated die (e.g., the dies 1002 of FIG. 10) or a wafer (e.g., the wafer 1000 of FIG. 10).

The integrated circuit device 1100 may include one or more device layers 1104 disposed on the die substrate 1102. The device layer 1104 may include features of one or more transistors 1140 (e.g., metal oxide semiconductor field-effect transistors (MOSFETs)) formed on the die substrate 1102. The transistors 1140 may include, for example, one or more source and/or drain (S/D) regions 1120, a gate 1122 to control current flow between the S/D regions 1120, and one or more S/D contacts 1124 to route electrical signals to/from the S/D regions 1120. The transistors 1140 may include additional features not depicted for the sake of clarity, such as device isolation regions, gate contacts, and the like. The transistors 1140 are not limited to the type and configuration depicted in FIG. 11 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

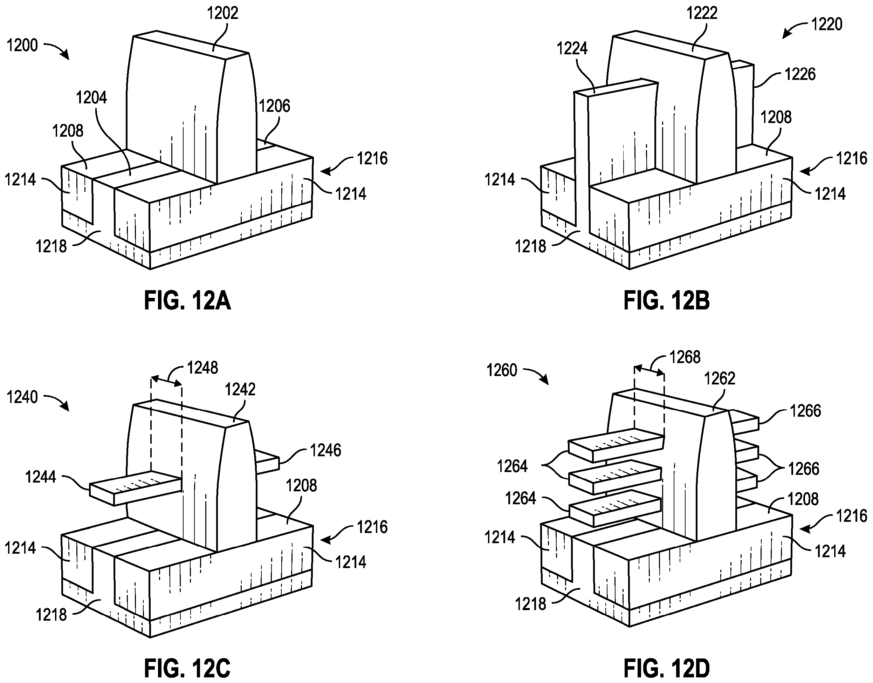

FIGS. 12A-12D are simplified perspective views of example planar, FinFET, gate-all-around, and stacked gate-all-around transistors. The transistors illustrated in FIGS. 12A-12D are formed on a substrate 1216 having a surface 1208. Isolation regions 1214 separate the source and drain regions of the transistors from other transistors and from a bulk region 1218 of the substrate 1216.

FIG. 12A is a perspective view of an example planar transistor 1200 comprising a gate 1202 that controls current flow between a source region 1204 and a drain region 1206. The transistor 1200 is planar in that the source region 1204 and the drain region 1206 are planar with respect to the substrate surface 1208.

FIG. 12B is a perspective view of an example FinFET transistor 1220 comprising a gate 1222 that controls current flow between a source region 1224 and a drain region 1226. The transistor 1220 is non-planar in that the source region 1224 and the drain region 1226 comprise "fins" that extend upwards from the substrate surface 1228. As the gate 1222 encompasses three sides of the semiconductor fin that extends from the source region 1224 to the drain region 1226, the transistor 1220 can be considered a tri-gate transistor. FIG. 12B illustrates one S/D fin extending through the gate 1222, but multiple S/D fins can extend through the gate of a FinFET transistor.

FIG. 12C is a perspective view of a gate-all-around (GAA) transistor 1240 comprising a gate 1242 that controls current flow between a source region 1244 and a drain region 1246. The transistor 1240 is non-planar in that the source region 1244 and the drain region 1246 are elevated from the substrate surface 1228.

FIG. 12D is a perspective view of a GAA transistor 1260 comprising a gate 1262 that controls current flow between multiple elevated source regions 1264 and multiple elevated drain regions 1266. The transistor 1260 is a stacked GAA transistor as the gate controls the flow of current between multiple elevated S/D regions stacked on top of each other. The transistors 1240 and 1260 are considered gate-all-around transistors as the gates encompass all sides of the semiconductor portions that extends from the source regions to the drain regions. The transistors 1240 and 1260 can alternatively be referred to as nanowire, nanosheet, or nanoribbon transistors depending on the width (e.g., widths 1248 and 1268 of transistors 1240 and 1260, respectively) of the semiconductor portions extending through the gate.

Returning to FIG. 11, a transistor 1140 may include a gate 1122 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1140 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1140 along the source-channel-drain direction, the gate electrode may consist of a U-shaped structure that includes a bottom portion substantially parallel to the surface of the die substrate 1102 and two sidewall portions that are substantially perpendicular to the top surface of the die substrate 1102. In other embodiments, at least one of the metal layers that form the gate electrode may simply be a planar layer that is substantially parallel to the top surface of the die substrate 1102 and does not include sidewall portions substantially perpendicular to the top surface of the die substrate 1102. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1120 may be formed within the die substrate 1102 adjacent to the gate 1122 of individual transistors 1140. The S/D regions 1120 may be formed using an implantation/diffusion process or an etching/deposition process, for example. In the former process, dopants such as boron, aluminum, antimony, phosphorous, or arsenic may be ion-implanted into the die substrate 1102 to form the S/D regions 1120. An annealing process that activates the dopants and causes them to diffuse farther into the die substrate 1102 may follow the ion-implantation process. In the latter process, the die substrate 1102 may first be etched to form recesses at the locations of the S/D regions 1120. An epitaxial deposition process may then be carried out to fill the recesses with material that is used to fabricate the S/D regions 1120. In some implementations, the S/D regions 1120 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1120 may be formed using one or more alternate semiconductor materials such as germanium or a group III-V material or alloy. In further embodiments, one or more layers of metal and/or metal alloys may be used to form the S/D regions 1120.

Electrical signals, such as power and/or input/output (I/O) signals, may be routed to and/or from the devices (e.g., transistors 1140) of the device layer 1104 through one or more interconnect layers disposed on the device layer 1104 (illustrated in FIG. 11 as interconnect layers 1106-1110). For example, electrically conductive features of the device layer 1104 (e.g., the gate 1122 and the S/D contacts 1124) may be electrically coupled with the interconnect structures 1128 of the interconnect layers 1106-1110. The one or more interconnect layers 1106-1110 may form a metallization stack (also referred to as an "ILD stack") 1119 of the integrated circuit device 1100.

The interconnect structures 1128 may be arranged within the interconnect layers 1106-1110 to route electrical signals according to a wide variety of designs; in particular, the arrangement is not limited to the particular configuration of interconnect structures 1128 depicted in FIG. 11. Although a particular number of interconnect layers 1106-1110 is depicted in FIG. 11, embodiments of the present disclosure include integrated circuit devices having more or fewer interconnect layers than depicted.

In some embodiments, the interconnect structures 1128 may include lines 1128a and/or vias 1128b filled with an electrically conductive material such as a metal. The lines 1128a may be arranged to route electrical signals in a direction of a plane that is substantially parallel with a surface of the die substrate 1102 upon which the device layer 1104 is formed. For example, the lines 1128a may route electrical signals in a direction in and out of the page and/or in a direction across the page. The vias 1128b may be arranged to route electrical signals in a direction of a plane that is substantially perpendicular to the surface of the die substrate 1102 upon which the device layer 1104 is formed. In some embodiments, the vias 1128b may electrically couple lines 1128a of different interconnect layers 1106-1110 together.

The interconnect layers 1106-1110 may include a dielectric material 1126 disposed between the interconnect structures 1128, as shown in FIG. 11. In some embodiments, dielectric material 1126 disposed between the interconnect structures 1128 in different ones of the interconnect layers 1106-1110 may have different compositions; in other embodiments, the composition of the dielectric material 1126 between different interconnect layers 1106-1110 may be the same. The device layer 1104 may include a dielectric material 1126 disposed between the transistors 1140 and a bottom layer of the metallization stack as well. The dielectric material 1126 included in the device layer 1104 may have a different composition than the dielectric material 1126 included in the interconnect layers 1106-1110; in other embodiments, the composition of the dielectric material 1126 in the device layer 1104 may be the same as a dielectric material 1126 included in any one of the interconnect layers 1106-1110.

A first interconnect layer 1106 (referred to as Metal 1 or "M1") may be formed directly on the device layer 1104. In some embodiments, the first interconnect layer 1106 may include lines 1128a and/or vias 1128b, as shown. The lines 1128a of the first interconnect layer 1106 may be coupled with contacts (e.g., the S/D contacts 1124) of the device layer 1104. The vias 1128b of the first interconnect layer 1106 may be coupled with the lines 1128a of a second interconnect layer 1108.

The second interconnect layer 1108 (referred to as Metal 2 or "M2") may be formed directly on the first interconnect layer 1106. In some embodiments, the second interconnect layer 1108 may include via 1128b to couple the lines 1128 of the second interconnect layer 1108 with the lines 1128a of a third interconnect layer 1110. Although the lines 1128a and the vias 1128b are structurally delineated with a line within individual interconnect layers for the sake of clarity, the lines 1128a and the vias 1128b may be structurally and/or materially contiguous (e.g., simultaneously filled during a dual-damascene process) in some embodiments.

The third interconnect layer 1110 (referred to as Metal 3 or "M3") (and additional interconnect layers, as desired) may be formed in succession on the second interconnect layer 1108 according to similar techniques and configurations described in connection with the second interconnect layer 1108 or the first interconnect layer 1106. In some embodiments, the interconnect layers that are "higher up" in the metallization stack 1119 in the integrated circuit device 1100 (i.e., farther away from the device layer 1104) may be thicker that the interconnect layers that are lower in the metallization stack 1119, with lines 1128a and vias 1128b in the higher interconnect layers being thicker than those in the lower interconnect layers.

The integrated circuit device 1100 may include a solder resist material 1134 (e.g., polyimide or similar material) and one or more conductive contacts 1136 formed on the interconnect layers 1106-1110. In FIG. 11, the conductive contacts 1136 are illustrated as taking the form of bond pads. The conductive contacts 1136 may be electrically coupled with the interconnect structures 1128 and configured to route the electrical signals of the transistor(s) 1140 to external devices. For example, solder bonds may be formed on the one or more conductive contacts 1136 to mechanically and/or electrically couple an integrated circuit die including the integrated circuit device 1100 with another component (e.g., a printed circuit board). The integrated circuit device 1100 may include additional or alternate structures to route the electrical signals from the interconnect layers 1106-1110; for example, the conductive contacts 1136 may include other analogous features (e.g., posts) that route the electrical signals to external components.

In some embodiments in which the integrated circuit device 1100 is a double-sided die, the integrated circuit device 1100 may include another metallization stack (not shown) on the opposite side of the device layer(s) 1104. This metallization stack may include multiple interconnect layers as discussed above with reference to the interconnect layers 1106-1110, to provide conductive pathways (e.g., including conductive lines and vias) between the device layer(s) 1104 and additional conductive contacts (not shown) on the opposite side of the integrated circuit device 1100 from the conductive contacts 1136.

In other embodiments in which the integrated circuit device 1100 is a double-sided die, the integrated circuit device 1100 may include one or more through silicon vias (TSVs) through the die substrate 1102; these TSVs may make contact with the device layer(s) 1104, and may provide conductive pathways between the device layer(s) 1104 and additional conductive contacts (not shown) on the opposite side of the integrated circuit device 1100 from the conductive contacts 1136. In some embodiments, TSVs extending through the substrate can be used for routing power and ground signals from conductive contacts on the opposite side of the integrated circuit device 1100 from the conductive contacts 1136 to the transistors 1140 and any other components integrated into the die 1100, and the metallization stack 1119 can be used to route I/O signals from the conductive contacts 1136 to transistors 1140 and any other components integrated into the die 1100.

Multiple integrated circuit devices 1100 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

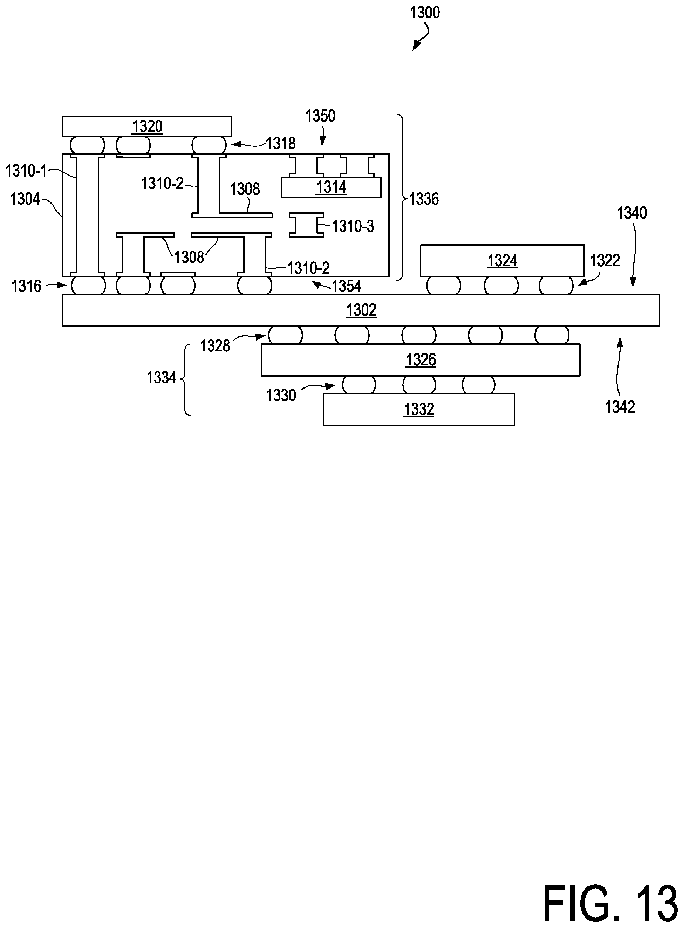

FIG. 13 is a cross-sectional side view of an integrated circuit device assembly 1300 that may include any of the integrated circuit components 100 disclosed herein. In some embodiments, the integrated circuit device assembly 1300 may be an integrated circuit component 100. The integrated circuit device assembly 1300 includes a number of components disposed on a circuit board 1302 (which may be a motherboard, system board, mainboard, etc.). The integrated circuit device assembly 1300 includes components disposed on a first face 1340 of the circuit board 1302 and an opposing second face 1342 of the circuit board 1302; generally, components may be disposed on one or both faces 1340 and 1342. Any of the integrated circuit components discussed below with reference to the integrated circuit device assembly 1300 may take the form of any suitable ones of the embodiments of the integrated circuit components 100 disclosed herein.

In some embodiments, the circuit board 1302 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1302. In other embodiments, the circuit board 1302 may be a non-PCB substrate. In some embodiments the circuit board 1302 may be, for example, the circuit board 102. The integrated circuit device assembly 1300 illustrated in FIG. 13 includes a package-on-interposer structure 1336 coupled to the first face 1340 of the circuit board 1302 by coupling components 1316. The coupling components 1316 may electrically and mechanically couple the package-on-interposer structure 1336 to the circuit board 1302, and may include solder balls (as shown in FIG. 13), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. The coupling components 1316 may serve as the coupling components illustrated or described for any of the substrate assembly or substrate assembly components described herein, as appropriate.

The package-on-interposer structure 1336 may include an integrated circuit component 1320 coupled to an interposer 1304 by coupling components 1318. The coupling components 1318 may take any suitable form for the application, such as the forms discussed above with reference to the coupling components 1316. Although a single integrated circuit component 1320 is shown in FIG. 13, multiple integrated circuit components may be coupled to the interposer 1304; indeed, additional interposers may be coupled to the interposer 1304. The interposer 1304 may provide an intervening substrate used to bridge the circuit board 1302 and the integrated circuit component 1320.

The integrated circuit component 1320 may be a packaged or unpacked integrated circuit product that includes one or more integrated circuit dies (e.g., the die 1002 of FIG. 10, the integrated circuit device 1100 of FIG. 11) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1320, a single monolithic integrated circuit die comprises solder bumps attached to contacts on the die. The solder bumps allow the die to be directly attached to the interposer 1304. The integrated circuit component 1320 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1320 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1320 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1320 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1304 may spread connections to a wider pitch or reroute a connection to a different connection. For example, the interposer 1304 may couple the integrated circuit component 1320 to a set of ball grid array (BGA) conductive contacts of the coupling components 1316 for coupling to the circuit board 1302. In the embodiment illustrated in FIG. 13, the integrated circuit component 1320 and the circuit board 1302 are attached to opposing sides of the interposer 1304; in other embodiments, the integrated circuit component 1320 and the circuit board 1302 may be attached to a same side of the interposer 1304. In some embodiments, three or more components may be interconnected by way of the interposer 1304.

In some embodiments, the interposer 1304 may be formed as a PCB, including multiple metal layers separated from one another by layers of dielectric material and interconnected by electrically conductive vias. In some embodiments, the interposer 1304 may be formed of an epoxy resin, a fiberglass-reinforced epoxy resin, an epoxy resin with inorganic fillers, a ceramic material, or a polymer material such as polyimide. In some embodiments, the interposer 1304 may be formed of alternate rigid or flexible materials that may include the same materials described above for use in a semiconductor substrate, such as silicon, germanium, and other group III-V and group IV materials. The interposer 1304 may include metal interconnects 1308 and vias 1310, including but not limited to through hole vias 1310-1 (that extend from a first face 1350 of the interposer 1304 to a second face 1354 of the interposer 1304), blind vias 1310-2 (that extend from the first or second faces 1350 or 1354 of the interposer 1304 to an internal metal layer), and buried vias 1310-3 (that connect internal metal layers).

In some embodiments, the interposer 1304 can comprise a silicon interposer. Through silicon vias (TSV) extending through the silicon interposer can connect connections on a first face of a silicon interposer to an opposing second face of the silicon interposer. In some embodiments, an interposer 1304 comprising a silicon interposer can further comprise one or more routing layers to route connections on a first face of the interposer 1304 to an opposing second face of the interposer 1304.

The interposer 1304 may further include embedded devices 1314, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1304. The package-on-interposer structure 1336 may take the form of any of the package-on-interposer structures known in the art.

The integrated circuit device assembly 1300 may include an integrated circuit component 1324 coupled to the first face 1340 of the circuit board 1302 by coupling components 1322. The coupling components 1322 may take the form of any of the embodiments discussed above with reference to the coupling components 1316, and the integrated circuit component 1324 may take the form of any of the embodiments discussed above with reference to the integrated circuit component 1320.

The integrated circuit device assembly 1300 illustrated in FIG. 13 includes a package-on-package structure 1334 coupled to the second face 1342 of the circuit board 1302 by coupling components 1328. The package-on-package structure 1334 may include an integrated circuit component 1326 and an integrated circuit component 1332 coupled together by coupling components 1330 such that the integrated circuit component 1326 is disposed between the circuit board 1302 and the integrated circuit component 1332. The coupling components 1328 and 1330 may take the form of any of the embodiments of the coupling components 1316 discussed above, and the integrated circuit components 1326 and 1332 may take the form of any of the embodiments of the integrated circuit component 1320 discussed above. The package-on-package structure 1334 may be configured in accordance with any of the package-on-package structures known in the art.

FIG. 14 is a block diagram of an example electrical device 1400 that may include one or more of the integrated circuit components 100 disclosed herein. For example, any suitable ones of the components of the electrical device 1400 may include one or more of the integrated circuit device assemblies 1300, integrated circuit components 1320, integrated circuit devices 1100, or integrated circuit dies 1002 disclosed herein, and may be arranged in any of the integrated circuit components 100 disclosed herein. A number of components are illustrated in FIG. 14 as included in the electrical device 1400, but any one or more of these components may be omitted or duplicated, as suitable for the application. In some embodiments, some or all of the components included in the electrical device 1400 may be attached to one or more motherboards mainboards, or system boards. In some embodiments, one or more of these components are fabricated onto a single system-on-a-chip (SoC) die.

Additionally, in various embodiments, the electrical device 1400 may not include one or more of the components illustrated in FIG. 14, but the electrical device 1400 may include interface circuitry for coupling to the one or more components. For example, the electrical device 1400 may not include a display device 1406, but may include display device interface circuitry (e.g., a connector and driver circuitry) to which a display device 1406 may be coupled. In another set of examples, the electrical device 1400 may not include an audio input device 1424 or an audio output device 1408, but may include audio input or output device interface circuitry (e.g., connectors and supporting circuitry) to which an audio input device 1424 or audio output device 1408 may be coupled.

The electrical device 1400 may include one or more processor units 1402 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1402 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1400 may include a memory 1404, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1404 may include memory that is located on the same integrated circuit die as the processor unit 1402. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1400 can comprise one or more processor units 1402 that are heterogeneous or asymmetric to another processor unit 1402 in the electrical device 1400. There can be a variety of differences between the processing units 1402 in a system in terms of a spectrum of metrics of merit including architectural, microarchitectural, thermal, power consumption characteristics, and the like. These differences can effectively manifest themselves as asymmetry and heterogeneity among the processor units 1402 in the electrical device 1400.

In some embodiments, the electrical device 1400 may include a communication component 1412 (e.g., one or more communication components). For example, the communication component 1412 can manage wireless communications for the transfer of data to and from the electrical device 1400. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1412 may operate in accordance with other wireless protocols in other embodiments. The electrical device 1400 may include an antenna 1422 to facilitate wireless communications and/or to receive other wireless communications (such as AM or FM radio transmissions).

In some embodiments, the communication component 1412 may manage wired communications, such as electrical, optical, or any other suitable communication protocols (e.g., IEEE 802.3 Ethernet standards). As noted above, the communication component 1412 may include multiple communication components. For instance, a first communication component 1412 may be dedicated to shorter-range wireless communications such as Wi-Fi or Bluetooth, and a second communication component 1412 may be dedicated to longer-range wireless communications such as global positioning system (GPS), EDGE, GPRS, CDMA, WiMAX, LTE, EV-DO, or others. In some embodiments, a first communication component 1412 may be dedicated to wireless communications, and a second communication component 1412 may be dedicated to wired communications.

The electrical device 1400 may include battery/power circuitry 1414. The battery/power circuitry 1414 may include one or more energy storage devices (e.g., batteries or capacitors) and/or circuitry for coupling components of the electrical device 1400 to an energy source separate from the electrical device 1400 (e.g., AC line power).

The electrical device 1400 may include a display device 1406 (or corresponding interface circuitry, as discussed above). The display device 1406 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1400 may include an audio output device 1408 (or corresponding interface circuitry, as discussed above). The audio output device 1408 may include any embedded or wired or wirelessly connected external device that generates an audible indicator, such as speakers, headsets, or earbuds.

The electrical device 1400 may include an audio input device 1424 (or corresponding interface circuitry, as discussed above). The audio input device 1424 may include any embedded or wired or wirelessly connected device that generates a signal representative of a sound, such as microphones, microphone arrays, or digital instruments (e.g., instruments having a musical instrument digital interface (MIDI) output). The electrical device 1400 may include a Global Navigation Satellite System (GNSS) device 1418 (or corresponding interface circuitry, as discussed above), such as a Global Positioning System (GPS) device. The GNSS device 1418 may be in communication with a satellite-based system and may determine a geolocation of the electrical device 1400 based on information received from one or more GNSS satellites, as known in the art.

The electrical device 1400 may include an other output device 1410 (or corresponding interface circuitry, as discussed above). Examples of the other output device 1410 may include an audio codec, a video codec, a printer, a wired or wireless transmitter for providing information to other devices, or an additional storage device.

The electrical device 1400 may include an other input device 1420 (or corresponding interface circuitry, as discussed above). Examples of the other input device 1420 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1400 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1400 may be any other electronic device that processes data. In some embodiments, the electrical device 1400 may comprise multiple discrete physical components. Given the range of devices that the electrical device 1400 can be manifested as in various embodiments, in some embodiments, the electrical device 1400 can be referred to as a computing device or a computing system.

### EXAMPLES

Illustrative examples of the technologies disclosed herein are provided below. An embodiment of the technologies may include any one or more, and any combination of, the examples described below.

Example 1 includes an apparatus comprising a semiconductor die comprising a plurality of traces, wherein a plurality of gaps are defined between the plurality of traces; and a liner disposed at least partially on top of the plurality of traces and adjacent the plurality of gaps, wherein the liner comprises aluminum.

Example 2 includes the subject matter of Example 1, and wherein the plurality of gaps are filled with a gas.

Example 3 includes the subject matter of any of Examples 1 and 2, and wherein the plurality of gaps are a vacuum.

Example 4 includes the subject matter of any of Examples 1-3, and wherein the liner has a thickness between 1.5 and 2.5 nanometers.

Example 5 includes the subject matter of any of Examples 1-4, and wherein individual traces of the plurality of traces have an aspect ratio of at least two.

Example 6 includes the subject matter of any of Examples 1-5, and wherein the plurality of traces have a pitch less than 30 nanometers.

Example 7 includes the subject matter of any of Examples 1-6, and wherein individual traces of the plurality of traces comprise ruthenium.

Example 8 includes the subject matter of any of Examples 1-7, and wherein individual traces of the plurality of traces comprise molybdenum or tungsten.

Example 9 includes the subject matter of any of Examples 1-8, and wherein the liner comprises a first layer, a second layer, and a third layer, wherein the first layer comprises silicon and oxygen, the second layer comprises aluminum and oxygen, and the third layer comprises silicon and oxygen.

Example 10 includes an apparatus comprising a plurality of traces on a layer of a semiconductor die, wherein a first end of individual traces of the plurality of traces is adjacent the layer; and a liner, wherein the liner is adjacent a second end of individual traces of the plurality of traces, each second end opposite the corresponding first end, wherein the liner comprises aluminum and oxygen, wherein a gap is defined between the liner and the semiconductor die.

Example 11 includes the subject matter of Example 10, and wherein the gap is filled with a gas.

Example 12 includes the subject matter of any of Examples 10 and 11, and wherein the gap is a vacuum.

Example 13 includes the subject matter of any of Examples 10-12, and wherein the liner has a thickness between 1.5 and 2.5 nanometers.

Example 14 includes the subject matter of any of Examples 10-13, and wherein individual traces of the plurality of traces have an aspect ratio of at least two.

Example 15 includes the subject matter of any of Examples 10-14, and wherein the plurality of traces have a pitch less than 30 nanometers.

Example 16 includes the subject matter of any of Examples 10-15, and wherein individual traces of the plurality of traces comprise ruthenium.

Example 17 includes the subject matter of any of Examples 10-16, and wherein individual traces of the plurality of traces comprise molybdenum or tungsten.

Example 18 includes the subject matter of any of Examples 10-17, and wherein the liner comprises a first layer, a second layer, and a third layer, wherein the first layer comprises silicon and oxygen, the second layer comprises aluminum and oxygen, and the third layer comprises silicon and oxygen.

Example 19 includes a method comprising forming a plurality of traces on a layer of a semiconductor die; depositing a sacrificial material between the plurality of traces; depositing a liner over the sacrificial material, wherein the liner comprises aluminum; and removing the sacrificial material to form a plurality of gaps between the plurality of traces.

Example 20 includes the subject matter of Example 19, and wherein forming the plurality of traces comprising forming the plurality of traces using subtractive manufacturing.

Example 21 includes the subject matter of any of Examples 19 and 20, and wherein the sacrificial material comprises carbon.

Example 22 includes the subject matter of any of Examples 19-21, and wherein the liner comprises oxygen.

Example 23 includes the subject matter of any of Examples 19-22, and further including depositing material over the liner without filling in the plurality of gaps.

Example 24 includes the subject matter of any of Examples 19-23, and wherein the plurality of gaps are filled with a gas.

Example 25 includes the subject matter of any of Examples 19-24, and wherein the plurality of gaps are a vacuum.

Example 26 includes the subject matter of any of Examples 19-25, and wherein the liner has a thickness between 1.5 and 2.5 nanometers.

Example 27 includes the subject matter of any of Examples 19-26, and wherein individual traces of the plurality of traces have an aspect ratio of at least two.

Example 28 includes the subject matter of any of Examples 19-27, and wherein the plurality of traces have a pitch less than 30 nanometers.

Example 29 includes the subject matter of any of Examples 19-28, and wherein individual traces of the plurality of traces comprise ruthenium.

Example 30 includes the subject matter of any of Examples 19-29, and wherein individual traces of the plurality of traces comprise molybdenum or tungsten.

Example 31 includes the subject matter of any of Examples 19-30, and wherein the liner comprises a first layer, a second layer, and a third layer, wherein the first layer comprises silicon and oxygen, the second layer comprises aluminum and oxygen, and the third layer comprises silicon and oxygen.

## Claims

1. An apparatus comprising:
a semiconductor die comprising:
a plurality of traces, wherein a plurality of gaps are defined between the plurality of traces; and
a liner disposed at least partially on top of the plurality of traces and adjacent the plurality of gaps, wherein the liner comprises aluminum.

2. The apparatus of claim 1, wherein the plurality of gaps are filled with a gas.

3. The apparatus of claim 1, wherein the plurality of gaps are a vacuum.

4. The apparatus of any one of claims 1-3, wherein the liner has a thickness between 1.5 and 2.5 nanometers.

5. The apparatus of any one of claims 1-4, wherein individual traces of the plurality of traces have an aspect ratio of at least two.

6. The apparatus of any one of claims 1-5, wherein the plurality of traces have a pitch less than 30 nanometers.

7. The apparatus of any one of claims 1-6, wherein individual traces of the plurality of traces comprise ruthenium.

8. The apparatus of any one of claims 1-6, wherein individual traces of the plurality of traces comprise molybdenum or tungsten.

9. The apparatus of any one of claims 1-8, wherein the liner comprises a first layer, a second layer, and a third layer, wherein the first layer comprises silicon and oxygen, the second layer comprises aluminum and oxygen, and the third layer comprises silicon and oxygen.

10. A method comprising:
forming a plurality of traces on a layer of a semiconductor die;
depositing a sacrificial material between the plurality of traces;
depositing a liner over the sacrificial material, wherein the liner comprises aluminum; and
removing the sacrificial material to form a plurality of gaps between the plurality of traces.

11. The method of claim 10, wherein forming the plurality of traces comprising forming the plurality of traces using subtractive manufacturing.

12. The method of any one of claims 10-11, wherein the sacrificial material comprises carbon.

13. The method of any one of claims 10-12, further comprising depositing material over the liner without filling in the plurality of gaps.

14. The method of any one of claims 10-13, wherein the plurality of gaps are filled with a gas.

15. The method of any one of claims 10-14, wherein individual traces of the plurality of traces comprise ruthenium.
